# FASCICULE DE BREVET EUROPEEN

(11) **EP 1 483 793 B1**
(45) Date de publication et mention de la délivrance du brevet: **31.08.2011**
(21) Numéro de dépôt: 03727583.1
(22) Date de dépôt: 12.03.2003
(51) Int. Cl.: H01L 29/872

(54) **DIODE SCHOTTKY DE PUISSANCE A SUBSTRAT SICOI, ET PROCEDE DE REALISATION D'UNE TELLE DIODE**
LEISTUNGS-SCHOTTKYDIODE MIT SICOI-SUBSTRAT UND DIESBEZÜGLICHES HERSTELLUNGSVERFAHREN
SCHOTTKY POWER DIODE COMPRISING A SICOI SUBSTRATE AND THE METHOD OF PRODUCING ONE SUCH DIODE

(30) Priorité: 14.03.2002 FR 0203165
(43) Date de publication de la demande: 08.12.2004
(73) Titulaire: Commissariat à l'Énergie Atomique et aux Énergies Alternatives, 75015 Paris (FR); S.O.I. Tec Silicon on Insulator Technologies, 38190 Bernin (FR)
(72) Inventeur: TEMPLIER, François, F-38500 VOIRON (FR); BILLON, Thierry, F-38500 COUBLEVIE (FR); DAVAL, Nicolas, 38000 Grenoble (FR)
(74) Mandataire: Poulin, Gérard
(86) Numéro de dépôt international: PCT/FR2003/000787
(87) Numéro de publication internationale: WO 2003/077321

(56) Documents cités:
- WO-A-01/37328
- WO-A-97/27629
- WO-A-99/39371
- US-A- 4 888 304
- PATENT ABSTRACTS OF JAPAN vol. 013, no. 201 (E-757), 12 mai 1989 (1989-05-12) & JP 01 023569 A (MATSUSHITA ELECTRONICS CORP), 26 janvier 1989 (1989-01-26)
- PATENT ABSTRACTS OF JAPAN vol. 1999, no. 08, 30 juin 1999 (1999-06-30) & JP 11 074498 A (N T T ELECTRON KK), 16 mars 1999 (1999-03-16)

## Description

### Domaine technique

La présente invention concerne un dispositif à jonction de puissance et un procédé de réalisation d'un tel dispositif.

On entend par jonction de puissance une jonction susceptible d'être parcourue par un courant fort de l'ordre de l'ampère ou de plusieurs ampères, et susceptible d'être soumise à une tension inverse de plusieurs centaines de volts. L'invention vise plus particulièrement la réalisation de diodes susceptibles de fonctionner sous une tension dans une gamme de 200 à 1500 volts.

L'invention trouve des applications dans les domaines de l'électronique de puissance et notamment dans l'électronique de puissance intégrée.

### Etat de la technique antérieure.

A l'heure actuelle, nombre de dispositifs électroniques de puissance fonctionnant dans une gamme de tension de 200 à 1500 volts utilisent des diodes bipolaires au silicium. Or, un inconvénient majeur des diodes au silicium est de présenter des pertes de commutation importantes. Ces pertes sont dues à la physique de fonctionnement de ces diodes bipolaires qui repose sur l'utilisation de porteurs minoritaires.

Dans des applications similaires, le carbure de silicium (SiC) permet de réaliser des diodes de type Schottky . Ces diodes présentent des performances statiques comparables à celles fabriquées à partir de silicium. De plus, les diodes Schottky à base de carbure de silicium ne souffrent pas de pertes de commutation. Cet avantage résulte de l'absence de porteurs minoritaires. On trouve ainsi des diodes au carbure de silicium avec des tensions de fonctionnement de l'ordre de 300 à 1500 volts.

L'utilisation du carbure de silicium et le développement de diodes à base de ce matériau restent cependant freinés par le coût très élevé du carbure de silicium. On estime que le coût d'un substrat en carbure de silicium peut représenter jusqu'à la moitié du coût d'un composant réalisé sur ce substrat.

Par ailleurs, les substrats de carbure de silicium ne sont ordinairement disponibles que sous la forme de plaquettes avec un diamètre limité. Le diamètre est généralement de 2 ou 3 pouces (environ 5,1 ou 7,6 cm). Le faible diamètre des substrats de carbure de silicium les rend incompatibles avec les équipements et lignes de fabrication propres aux techniques du silicium. Les plaquettes de silicium sont en effet disponibles avec des diamètres plus importants. Ainsi, la nécessité de recourir à des équipements spéciaux augmente encore le prix des composants à base de carbure de silicium.

En ce qui concerne l'intégration système, l'état de la technique est encore illustré par les documents (1) et (2). Ceux-ci illustrent la fabrication de systèmes de commutation sur des substrats de type SOI mais qui ne répondent pas aux critères d'intégration et de puissance retenus pour les applications visées par l'invention.

### Exposé de l'invention

Un but de l'invention est de proposer un dispositif à jonction de puissance, et son procédé de fabrication, qui ne présentent pas les limitation évoquées ci-dessus en relation avec la description de l'état de la technique.

Un but est en particulier de proposer un tel dispositif susceptible d'être fabriqué sur des lignes classiques de fabrication adaptées au traitement de substrats de silicium.

Un but est encore de proposer un dispositif et un procédé de faible coût.

Enfin, un but est de proposer un dispositif fiable capable de fonctionner avec des tenues en tensions inverses dans une gamme de 200 à 1500 volts et un courant direct de 1 à 10 A.

Pour atteindre ces buts, l'invention selon la revendication 1 concerne plus précisément un dispositif à jonction de puissance comprenant un substrat de type SiCOI avec une couche de carbure de silicium isolée d'un support massif par une couche enterrée d'isolant, et comprenant au moins un contact Schottky entre une première couche métallique et la couche superficielle de carbure de silicium, la première couche métallique constituant une anode.

Le dispositif selon l invention est défini par les caractéristiques de la revendication 1. Au sens de l'invention, on entend par dispositif à jonction de puissance un dispositif qui comporte une jonction susceptible d'être utilisée comme diode de puissance. Le dispositif ne se limite toutefois pas nécessairement à une diode. Il peut comporter également un ou plusieurs commutateurs et éventuellement des moyens de commande associés, et intégrés sur le même substrat.

Grâce à l'invention et notamment à l'utilisation d'un substrat de type SiCOI le coût de fabrication d'un dispositif à jonction de puissance peut être largement réduit. Une raison en est que le substrat de type SiCOI est moins coûteux qu'un substrat de carbure de silicium massif. De plus, les substrats de type SiCOI sont disponibles avec des diamètres compatibles avec les outillages propres au traitement des plaquettes de silicium.

Selon un aspect particulier de l'invention, le dispositif peut être conformé de telle façon que la couche métallique formant la jonction Schottky soit en contact avec un flanc de la couche de carbure de silicium, le flanc formant un angle sortant par rapport à une face principale de cette couche.

L'angle que forme le flanc de la couche de carbure de silicium permet d'optimiser le contact entre la première couche métallique et la couche de SiC semiconducteur. Cet angle a aussi une influence sur la tenue en tension inverse. Par ailleurs, une conduction électrique dans la couche de carbure de silicium, parallèlement à cette couche, permet de réduire considérablement le risque de défaillances dues à des défauts cristallins. Ces défaillances telles que des microcavités affectent en effet principalement une conduction transversale aux couches.

Dans une réalisation particulière, l'angle, mesuré par rapport à une face principale de la couche de carbure de silicium, en contact avec la couche enterrée d'isolant, peut avoir une valeur de préférence voisine de 45°.

Selon un autre aspect! particulier de l'invention, le dispositif peut comporter une couche superficielle d'isolant recouvrant la couche de carbure de silicium. Dans ce cas, la première couche métallique, formant anode, s'étend au moins en partie sur un flanc de la couche superficielle d'isolant jouxtant le flanc de la couche de carbure de silicium. La couche isolante, en jouxtant le flanc de la couche de carbure de silicium, peut être avantageusement mise à profit pour constituer une projection par réduction de champ autour du contact Schottky. Elle peut à cet effet présenter également une pente ajustée pour être voisine de la pente formée par le flanc de la couche de carbure de silicium, ou identique à celle-ci.

Cette caractéristique permet d'augmenter la tenue en tension du dispositif.

Comme évoqué précédemment, le dispositif peut comporter une pluralité de diodes ou une combinaison de diodes et d'autres composants. En particulier, le dispositif peut comporter au moins une diode de puissance et au moins un transistor, le transistor présentant un canal formé dans la couche de carbure de silicium.

Selon une particularité du dispositif, la couche métallique formant anode, c'est-à-dire la couche métallique en contact Schottky avec la couche de carbure de silicium, peut s'étendre jusque sur une partie massive du substrat, en silicium. La partie massive du substrat peut ainsi être utilisée pour la réalisation d'une prise de contact « arrière » pour l'anode. En effet, une face du substrat, opposée à la face portant la couche de carbure de silicium, peut être métallisée pour former une prise de contact d'anode et faciliter ainsi la mise sous boîtier du dispositif.

La mesure consistant à relier l'anode de la jonction au substrat permet en outre d'augmenter sa tenue en tension inverse.

Selon une autre particularité de l'invention, le dispositif peut présenter une première couche métallique d'anode et en outre une deuxième couche métallique de cathode, en contact ohmique avec la couche de carbure de silicium. Les première et deuxième couches métalliques peuvent présenter respectivement des parties formant peigne, les parties formant peigne des première et deuxième couches métalliques étant interdigitées.

La conformation d'une partie des couches métalliques sous la forme de peignes interdigités permet d'obtenir des courants directs de plus forte intensité.

L'invention concerne également un procédé de fabrication d'un dispositif à jonction sur un substrat SiCOI tel que décrit. Le procédé comprend les étapes énumérées dans la revendication 9.

L'ordre des étapes a) et b) Peut éventuellement être interverti.

La gravure localisée pratiquée lors de l'étape b) du procédé est de préférence une gravure utilisant un masque de gravure et un agent de gravure avec une sélectivité limitée par rapport au masque de gravure, de façon à conférer une pente au flanc latéral.

D'autres caractéristiques et avantages de l'invention ressortiront de la description qui va suivre, en référence aux figures des dessins annexés. Cette description est donnée à titre purement illustrative et non limitatif.

### Brève description des figures.

La figure 1 est une coupe schématique partielle d'un substrat de type SiCOI utilisable pour la réalisation d'un dispositif conforme à l'invention.
Les figures 2, 3 et 4 sont des coupes schématiques partielles du substrat, de la figure 1, illustrant des étapes de fabrication d'une cathode d'un dispositif conforme à l'invention.
Les figures 5 à 7 sont des coupes schématiques partielles du dispositif de la figure 4, illustrant des étapes de fabrication d'une anode d'un dispositif conforme à l'invention.
La figure 8 est une coupe schématique partielle du dispositif de la figure 7 et illustre une étape de conditionnement.
Les figures 9 à 11 sont des coupes schématiques partielles du dispositif de la figure 4, illustrant des étapes de fabrication d'une anode d'un dispositif conforme à l'invention, selon une variante du procédé illustré par les figures 5 à 8.
La figure 12 est une vue d'une face principale d'un dispositif conforme à l'invention.
Les figures 13 et 14 sont des coupes schématiques partielles d'un dispositif conforme à l'invention et illustrent différents aspects de la réalisation d'un tel dispositif.

### Description détaillée de modes de mise en oeuvre de l'invention.

Dans la description qui suit, des parties identiques, similaires ou équivalentes des différentes figures sont repérées par les mêmes signes de référence pour faciliter le report entre les figures. Par ailleurs, et dans un souci de clarté des figures, tous les éléments ne sont pas représentés selon une échelle uniforme. Enfin, la description indique un certain nombre de valeurs chiffrées ou de paramètres. Ces valeurs ou paramètres ne sont pas indispensables à la mise en oeuvre de l'invention mais indiquent simplement des conditions particulièrement favorables de sa mise en oeuvre.

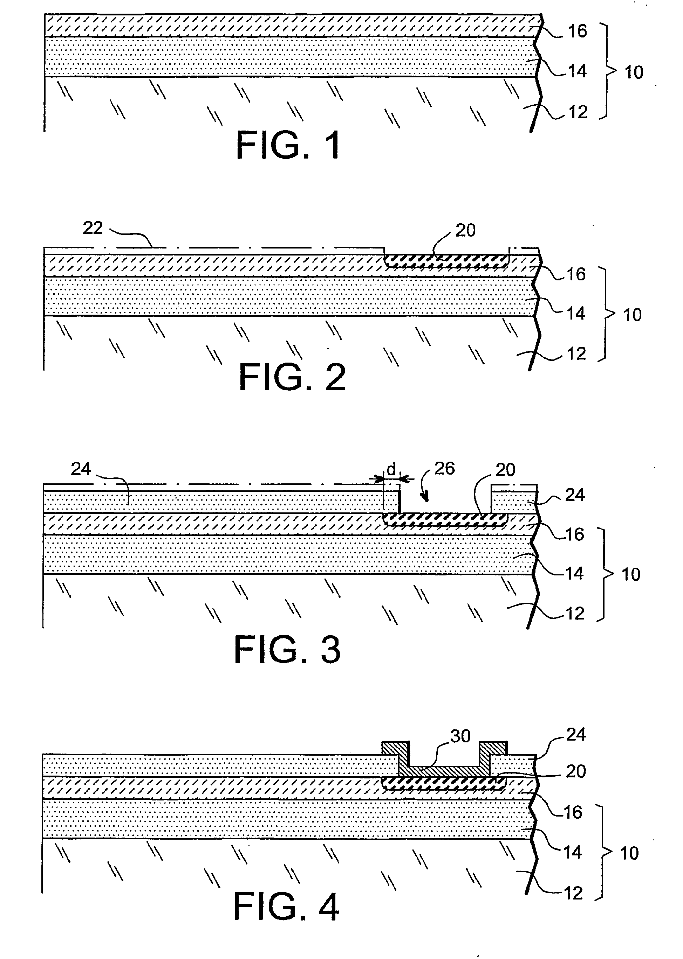

La figure 1 montre un substrat 10 de type SiCOI (carbure de silicium sur isolant). Un tel substrat peut être réalisé notamment en mettant en oeuvre une technique de clivage connue et désignée par "Smart Cut". Il comprend, dans l'exemple illustré, une couche épaisse de silicium 12 constituant un support mécanique. Cette couche est recouverte dans l'ordre par une couche isolante enterrée 14 en oxyde de silicium et par une couche superficielle 16 en carbure de silicium monocristallin. Le silicium peut être remplacé par un autre matériau, de même que la couche isolante. Cette dernière peut être, par exemple en Si₃N₄.

Dans l'exemple particulier décrit ici, la couche 12 de silicium présente une épaisseur comprise entre 100 et 500µm et est dopée avec des impuretés de type N. Le dopage est choisi suffisant pour permettre le passage de courant, notamment lorsqu'on envisage d'utiliser le substrat comme prise de contact arrière. Cet aspect est encore décrit ultérieurement.

La couche enterrée d'oxyde de silicium a une fonction d'isolation électrique entre les différentes parties actives du dispositif. Son épaisseur est ajustée en fonction des besoins en tenue en tension inverse. Son épaisseur est, par exemple, comprise entre 1 et 5 µm, en considérant qu'une épaisseur de 1 µm permet de tenir une tension de 200 volts environ.

La couche superficielle de SiC monocristallin présente une épaisseur comprise entre 0,1 et 3 µm. Elle est dopée de type P ou N avec une concentration d'impuretés de l'ordre de 10¹⁵ à 5.10¹⁷ cm⁻³ .

Une première étape de fabrication d'un contact ohmique est représentée à la figure 2. Elle comprend la formation d'une zone dopée 20 dans la couche de carbure de silicium. La zone dopée est du même type de conductivité que la couche de carbure de silicium 16 mais présente une plus forte concentration d'impuretés. Il s'agit, par exemple, une implantation d'azote, conduisant à un dopage de type N+, et permettant la formation d'un bon contact ohmique avec un métal déposé ultérieurement. L'extension latérale de la zone dopée est fixée par un masque d'implantation 22 en oxyde de silicium, mis en forme selon des techniques usuelles de photolithographie. L'extension en profondeur de la zone dopée est de l'ordre de 100 à 200 nm. Elle est fixée par l'énergie d'implantation.

Après un recuit d'implantation, prévu pour l'activation des espèces dopantes, le masque d'implantation 22 est retiré.

Une étape suivante, illustrée par la figure 2 comprend le dépôt à la surface de la couche de carbure de silicium 16 d'une couche d'isolant 24 en un matériau diélectrique tel que l'oxyde ou le nitrure de silicium. Le dépôt de cette couche a préférentiellement lieu à haute température pour lui conférer une bonne qualité diélectrique. Il s'agit, par exemple, d'une couche d'oxyde de silicium d'une épaisseur de 3 µm obtenue par un dépôt chimique en phase vapeur (CVD).

La couche d'isolant 24 est mise en forme par gravure pour y pratiquer une ouverture 26, et mettre à nu une partie de la zone dopée 20 de la couche de carbure de silicium. La gravure a préférentiellement lieu par plasma fluoré de CHF₃ ou SF₆ de façon à contrôler avec précision les dimensions de l'ouverture. Celles-ci sont par ailleurs fixées par un masque, indiqué sommairement en trait mixte.

On peut observer sur la figure que l'ouverture 26 présente une aire inférieure à celle de la zone dopée et coïncide avec une partie centrale de cette zone. Ceci permet de ménager une partie marginale de la zone dopée, recouverte par la couche d'isolant 24. La partie marginale dont l'extension est notée d, fixe une distance entre une couche de métal d'une borne de cathode, décrite ultérieurement, et le bord de la zone dopée. Cette mesure permet de réduire un champ électrique de cathode et ainsi d'augmenter la tenue en tension du dispositif.

La formation de la borne de cathode est illustrée par la figure 4. Une couche de métal 30, tel que W, Ni, Ti, est déposée sur le substrat de façon à venir en contact avec la zone dopée 20 et y former un contact ohmique. Dans l'exemple décrit, une couche de tungstène d'une épaisseur de 50 à 500 nm est déposée par pulvérisation cathodique. Elle est ensuite gravée par voie humide ou par plasma, selon un masque, non représenté, de façon à fixer la forme de la borne de cathode. Un traitement thermique, à une température de l'ordre de 900 à 1300 °C selon les matériaux, est effectué pendant 2 minutes pour procéder à un recuit du contact ohmique. Cette opération est réalisée après le retrait du masque.

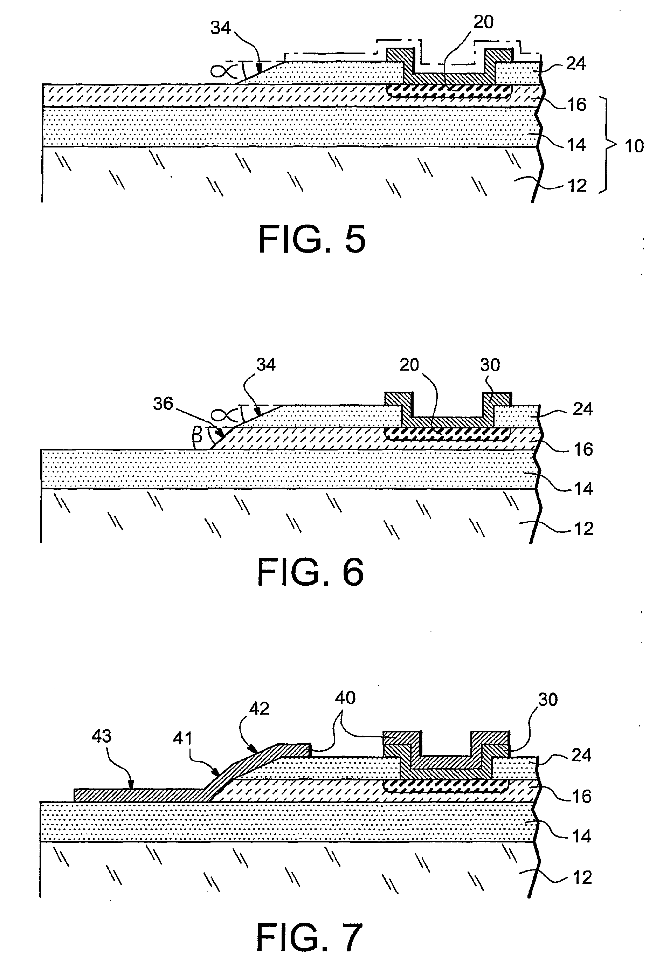

La description qui suit est relative à la formation d'une borne d'anode. Une première étape de cette opération, illustrée par la figure 5 comprend une gravure de la couche d'isolant 24 pour mettre à nu une nouvelle partie de la couche de carbure de silicium 16. Lors de cette gravure, une partie de la couche d'isolant 24 reste protégée par un masque indiqué en trait discontinu. Les paramètres de gravure, et en particulier la sélectivité de gravure, sont de préférence ajustés pour conférer à la couche d'isolant 24 un flanc de gravure 34 qui présente une pente selon un angle α de 20° à 80° par rapport au plan d'une face principale de la couche.

Le masque de gravure est ensuite retiré.

Après la gravure de la couche d'isolant 24, on procède également à une gravure de la couche de carbure de silicium sous-jacente. Cette gravure, illustrée par la figure 6, a lieu en utilisant le reliquat de la couche d'isolant comme masque de gravure.

Les paramètres de gravure sont encore ajustés de façon à contrôler la sélectivité par rapport à la couche d'isolant 24, et ainsi dégager un flanc latéral 36 de la couche de carbure de silicium 16 qui forme également un angle par rapport aux faces principales. Cet angle, noté β, présente une valeur comprise entre 20° et 80°, par exemple 45°. La gravure peut avoir lieu au moyen d'un plasma fluoré, tel que SF₆ auquel on ajoute plus ou moins d'oxygène pour modifier la sélectivité par rapport à la couche d'isolant. Une sélectivité plus ou moins forte permet de former une pente plus ou mois abrupte du flanc latéral 36. La gravure a lieu avec arrêt sur la couche isolante enterrée 14. On considère, par simplification, que l'angle α n'est pas modifié lors de cette gravure.

Les pentes α et β conférées aux flancs latéraux 34 et 36 de la couche d'isolant 24 et de la couche de carbure de silicium 14, permettent de faciliter la formation d'une jonction Schottky métallique sur la couche de carbure de silicium. Elles dictent aussi l'encombrement et les caractéristiques électriques du dispositif.

Une pente plus douce, c'est-à-dire un angle plus petit, permet d'augmenter la surface d'une jonction formée sur la couche de carbure de silicium 16 et, partant, la tenue en tension de la jonction. Une pente douce augmente cependant l'encombrement du composant à la surface du substrat. Au contraire, une pente plus abrupte autorise un gain de place, au prix toutefois d'une difficulté technique.

La figure 7, illustre la formation de la jonction Schottky. Une couche de jonction 40, comprenant une couche métallique, de préférence du titane ou du nickel, est déposée sur le substrat de façon à recouvrir notamment le flanc latéral 36 de la couche de carbure de silicium 16. La couche métallique, d'une épaisseur de l'ordre de 50 à 300 nm, est déposée par pulvérisation ou par évaporation sur l'ensemble de la face exposée, puis mise en forme par gravure selon un masque non représenté.

La couche de jonction peut être formée de plusieurs sous-couches. Dans un exemple particulier, elle peut comporter dans l'ordre une couche métallique de Ti, une couche intermédiaire de TiN et une couche superficielle de Al. Ces couches ne sont pas détaillées sur les figures pour des raisons de clarté.

La couche métallique de titane forme la jonction proprement dite avec la couche de carbure de silicium. La couche d'aluminium a pour fonction de diminuer la résistance de la métallisation et d'augmenter ainsi la densité de courant admissible en mode passant. L'aluminium permet en outre de faciliter la soudure de fils de connexion extérieurs, également en aluminium, lors de la mise sous boîtier du dispositif. Les couches indiquées ci-dessus peuvent aussi, comme le montre la figure 7, recouvrir la première couche métallique 30 formant la borne de cathode. Bien que sur la figure la couche de jonction 40 recouvre exactement la couche de contact ohmique 30 de la borne de cathode, elle peut aussi déborder autour de la borne de cathode ou plus simplement ne pas recouvrir la couche 30 de la borne de cathode.

La couche de jonction 40, présente plusieurs parties dont les fonctions sont différentes. Une première partie 41 est en contact avec la couche de carbure de silicium 16. Comme indiqué ci-dessus, cette partie remplit la fonction de jonction Schottky.

Une deuxième partie 42 recouvre en partie la couche superficielle d'isolant 24, et notamment la face latérale 34 de cette couche. Elle a une fonction de plaque de champ. En d'autres termes, elle a pour but de déplacer une zone critique de fort champ électrique depuis le bord de la jonction Schottky vers une partie plus épaisse de la couche superficielle d'isolant 24. On rappelle que la couche de carbure de silicium 16 est gravée en utilisant la couche superficielle d'isolant 24 comme masque de gravure. Les faces latérales de ces couches sont donc auto-alignées.

Une troisième partie de la couche de jonction, repérée par la référence 43, repose sur une partie de la couche isolante enterrée 14, mise à nu lors de la gravure de la couche de carbure de silicium 16. On rappelle également que cette couche enterrée est utilisée comme couche d'arrêt de gravure. La troisième partie 43 est mise à profit pour réaliser une connexion du composant vers l'extérieur.

Lorsque les angles α et β que forment les flancs latéraux 34, 36 des couches 16 et 24 ne sont pas trop abrupts, un recouvrement homogène par la couche de jonction 40 peut être obtenu.

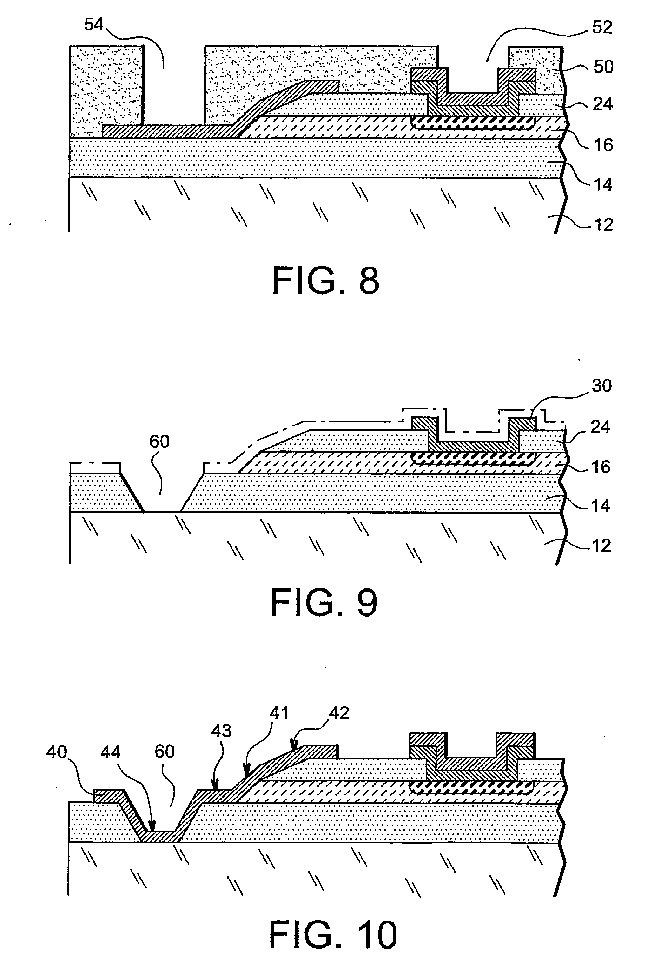

La figure 8 montre une dernière étape comprenant la passivation du dispositif. Une couche de passivation 50 en un matériau tel que du polyimide, ou un autre matériau isolant est déposé sur le dispositif de façon à recouvrir les parties décrites précédemment. Cette couche d'une épaisseur de l'ordre de 2 à 20 µm peut être déposée, par exemple, à la tournette. Elle permet de rendre plane la surface du composant. Des puits 52 ,54 d'accès à l'anode et à la cathode peuvent être pratiqués dans cette couche pour permettre une connexion au boîtier par des fils d'aluminium.

Dans un dispositif conforme à la figure 8 les prises de contact d'anode et de cathode ont lieu sur une même face, en l'occurrence la face portant la couche de passivation 50. Par commodité, cette face est désignée par « face avant ». La face opposée, formée par la couche épaisse de silicium 12, est désignée par « face arrière ».

On décrit, en relation avec les figures suivantes, une variante du dispositif avec une prise de contact d'anode en face arrière.

La figure 9 illustre une étape de gravure qui prend place entre les étapes illustrées par les figures 6 et 7. Lors de cette étape, une ouverture d'accès 60 à la couche épaisse de silicium est gravée à travers la couche isolante enterrée 14. L'ouverture obtenue par voie humide ou par plasma est localisée dans la partie de la couche isolante enterrée 14 préalablement mise à nu lors de la gravure de la couche de carbure de silicium 16. L'emplacement de l'ouverture est fixé par un masque représenté sommairement en trait mixte.

La figure 10 montre que la couche métallique de jonction 40, formée par la suite, présente désormais une partie 44 qui s'étend dans l'ouverture d'accès 60 pour venir en contact ohmique avec la couche de silicium 12. On peut observer sur les figures 9 et 10 que la gravure de la couche isolante enterrée 14 a été également pratiquée de façon à obtenir des flancs en pente douce. La pente est par exemple comprise entre 30° et 70°. Ceci permet une bonne continuité de la couche métallique de jonction 40.

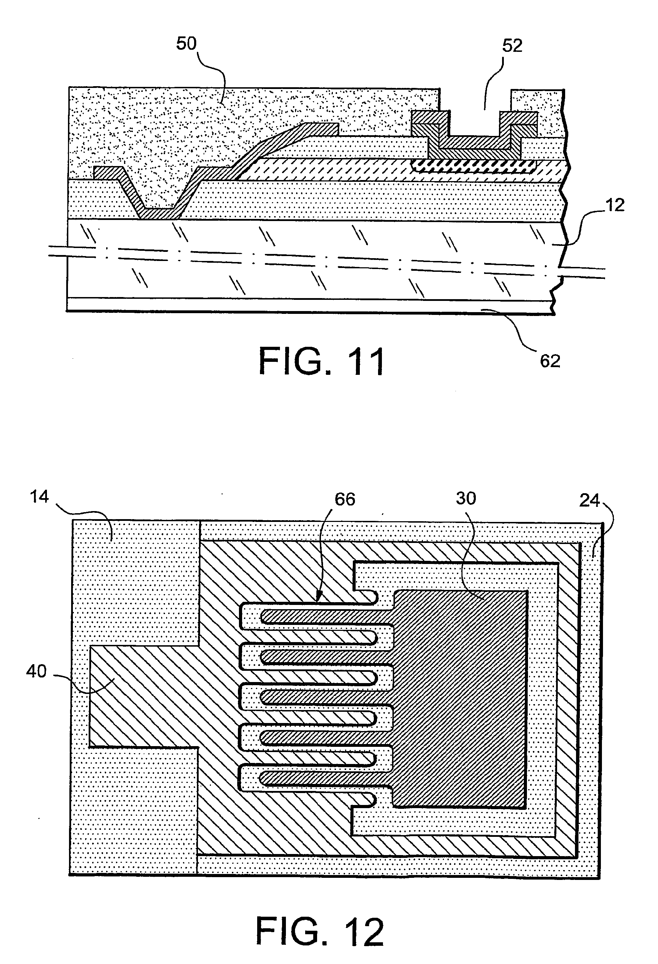

La figure 11 montre une étape finale de conditionnement du composant. Une couche de passivation 50 recouvre la face avant et est pourvue d'un puits d'accès 52 pour la borne de cathode.

On remarque également sur la face arrière du composant une couche de métallisation 62 qui recouvre la couche de silicium 12. Il s'agit, par exemple, d'une triple couche comprenant dans l'ordre une couche de Ti, de Ni puis d'Au. Une telle structure permet de fournir une excellente prise de contact et facilite le brasage ultérieur du dispositif sur un boîtier. L'ouverture 54 décrite en référence à la figure 8 est devenue inutile. Dans le procédé de fabrication ci-dessus, les première et deuxième couches métalliques, et plus généralement les couches de contact ohmique et les couches de jonction peuvent être mises en forme pour leur conférer des motifs particuliers. Ceci peut avoir lieu lors des étapes illustrées par les figures 4, 7 et 10 notamment.

La figure 12 montre une configuration particulière de ces couches. La couche de jonction 40 formant anode et la première couche métallique 30 formant cathode s'étendent sur une région intermédiaire 66 dans laquelle ces couches présentent une structure de peignes interdigités. Une telle structure permet d'augmenter le courant en régime de polarisation direct.

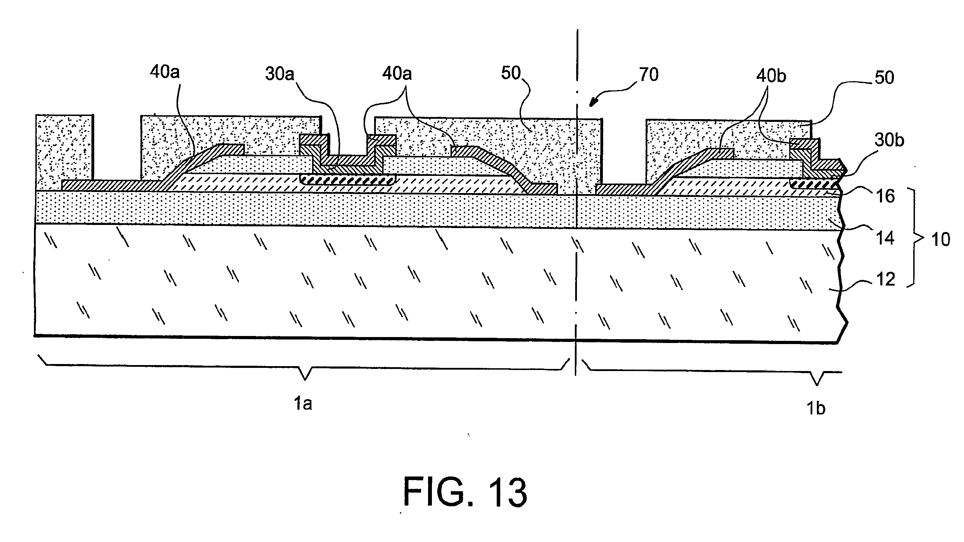

La fabrication de diodes conformément au procédé indiqué permet d'obtenir automatiquement une isolation entre les différents composants. A titre d'illustration, la figure 13 montre en coupe deux diodes réalisées sur un même substrat 10. Une première diode, complète, est repérée avec la référence la et une deuxième diode, dont une moitié seulement est représentée, est repérée avec la référence 1b. Pour distinguer les bornes d'anode et de cathode des deux diodes, les références des couches métalliques 30, 40, sont suivies des lettres a et b correspondant aux diodes 1a et 1b. On peut se reporter à la description qui précède, au sujet de ces couches. Dans une région intermédiaire 70 entre les deux diodes la couche de passivation 50 se retrouve directement en contact avec la couche isolante enterrée 14. Ceci résulte de la gravure de la couche de carbure de silicium avec arrêt sur la couche isolante enterrée. La région 70 fournit ainsi une parfaite isolation électrique entre les composants. Une éventuelle connexion entre composants pourrait être obtenue lors de la mise en forme de la couche de jonction 40a, 40b ou de la couche métallique de contact 30a,30b. Ces couches sont en effet gravées respectivement de façon concomitante pour l'ensemble des composants réalisés sur le même substrat. Une ou plusieurs diodes peuvent ainsi être connectées en série ou en parallèle.

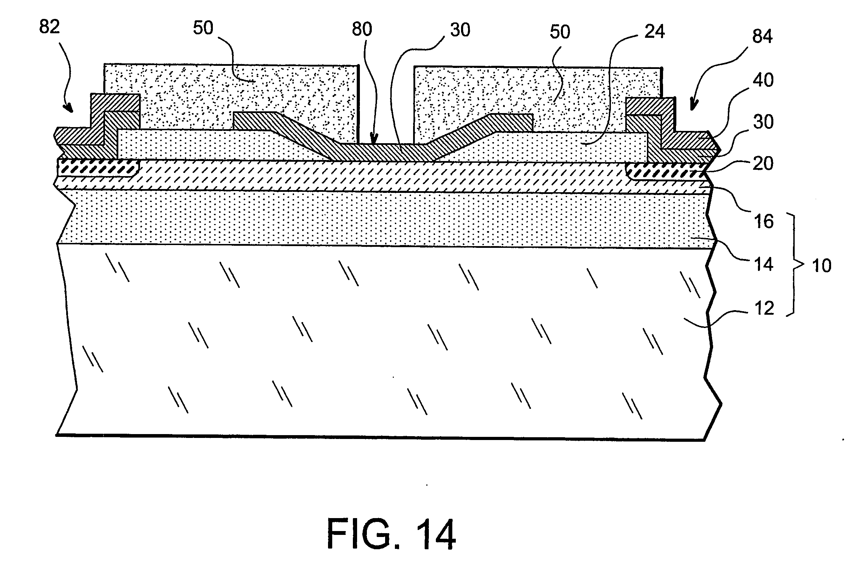

Un dispositif conforme à l'invention peut comporter, outre une diode, d'autres composants tels que notamment un transistor à effet de champ. Ceci est illustré par la figure 14 qui montre une possibilité d'intégrer sur le même substrat un tel transistor. Le transistor présente des bornes de grille, de source et de drain repérées par les références 80, 82, 84 respectivement. La fabrication des source et drain 82, 84 est identique à celle des bornes de contact ohmique des diodes. En d'autres termes, la couche métallique de contact 30 est en contact avec des zones dopées 20 de la couche de carbure de silicium 16. On peut ainsi se référer à la description qui précède. La grille est obtenue en pratiquant une ouverture dans la couche d'isolant superficielle 24 puis en y déposant la couche métallique de contact 30. L'ouverture peut être réalisée avec des flancs évasés, notamment si on utilise le procédé décrit pour les diodes Schottky, c'est-à-dire si on veut obtenir à la fois des transistors MESFET et des diodes Schottky. Les flancs évasés ne sont toutefois pas nécessaires au fonctionnement des transistors. L'ouverture de grille pratiquée dans la couche d'isolant 24 a lieu par gravure avec arrêt sur la couche de carbure de silicium. La portion de couche 30 mise en forme pour former la grille 80 repose ainsi sur une face principale de la couche de carbure de silicium et non sur un flanc latéral de celle-ci. La grille forme une jonction Schottky. La couche de carbure de silicium 16 constitue ici le canal du transistor.

### DOCUMENTS CITES

(1) US 6 229 179
(2) US 6 127 703
(3) EP-A-1 111 688

## Revendications

1. Dispositif à jonction de puissance comprenant un substrat (10) de type SiCOI avec une couche de carbure de silicium (16) isolée d'un support massif (12) par une couche enterrée d'isolant (14), et comprenant au moins un contact Schottky entre une première couche métallique (40) et la couche superficielle de carbure de silicium (16), la première couche métallique (40) constituant une anode, la première couche métallique (40) étant en contact avec un flanc (36) de la couche de carbure de silicium (16) pour y constituer le contact Schottky, le flanc formant un angle (β), mesuré par rapport à une race principale de la couche de carbure de silicium en contact avec la couche enterrée d'isolant (14), ayant une valeur comprise entre 20° et 80°, moyennant quoi la conduction électrique dans la couche du carbure de silicium s'effectue parallèlement à celle-ci.

2. Dispositif selon la revendication 1, dans lequel l'angle (β) a une valeur voisine de 45°.

3. Dispositif selon la revendication 1, comprenant une couche superficielle d'isolant (24) recouvrant la couche de carbure de silicium, et dans lequel la couche métallique (40) formant anode s'étend au moins en partie sur un flanc (34) de la couche superficielle d'isolant (24) recouvrant la couche de carbure de silicium (16) et jouxtant le flanc (36) de la couche de carbure de silicium.

4. Dispositif selon la revendication 1, comprenant une deuxième couche métallique (30) en contact ohmique avec la couche de carbure de silicium et formant une cathode.

5. Dispositif selon la revendication 1, dans lequel la première couche métallique (40), formant anode s'étend jusque sur le support massif, en silicium.

6. Dispositif selon la revendication 1, comprenant au moins une diode de puissance et au moins un transistor, le transistor présentant un canal formé dans la couche de carbure de silicium.

7. Dispositif selon la revendication 1, comprenant une pluralité de diodes de puissance connectées en série ou en parallèle.

8. Dispositif selon la revendication 4, dans lequel la première et la deuxième couche métallique présentent respectivement des parties formant peigne, les parties formant peigne des première et deuxième couches métalliques étant interdigitées.

9. Procédé de fabrication d'une diode de puissance sur un substrat de type SiCOI avec une couche de carbure de silicium (16) isolée d'un support massif de silicium (12) par une couche enterrée d'isolant (14), le procédé comprenant les étapes suivantes :
a) la formation d'une prise de contact ohmique sur une face de la couche de carbure de silicium, opposée à la couche enterrée d'isolant,
b) la gravure localisée de la couche de carbure de silicium en dehors d'une région du contact ohmique pour dégager au moins un flanc latéral (36) sur la couche de carbure de silicium (16), le flanc formant un angle (β), mesuré par rapport à une face principale de la couche de carbure de silicium en contact avec la couche enterrée d'isolant (14), ayant une valeur comprise entre 20° et 80°, et
c) la formation d'un contact Schottky sur le flanc latéral selon la revendication 1.

10. Procédé selon la revendication 9, dans lequel la gravure localisée est une gravure utilisant un masque de gravure et un agent de gravure avec une sélectivité limitée par rapport au masque de gravure, de façon à conférer une pente au flanc latéral.

11. Procédé selon la revendication 9, dans lequel l'étape a) comprend la formation sur la couche de carbure de silicium d'une couche superficielle d'isolant (24).

12. Procédé selon la revendication 9, dans lequel on utilise la couche superficielle d'isolant (24) comme masque de gravure lors de l'étape b.

13. Procédé selon la revendication 9, dans lequel on forme le contact Schottky entre la première couche métallique (40) et la couche de carbure de silicium (16), la première couche métallique (40) étant prolongée en partie sur la couche superficielle d'isolant (24).

14. Procédé selon la revendication 9, dans lequel on forme le contact Schottky entre la première couche métallique (40) et la couche de carbure de silicium (16), la première couche métallique (40) étant prolongée jusque sur le support massif (12), à travers une ouverture préalablement pratiquée dans la couche d'isolant enterrée (14).

15. Procédé selon la revendication 9, dans lequel l'étape de formation d'une prise de contact ohmique comprend la formation d'une zone dopée (20) dans la couche de carbure de silicium, puis le dépôt d'une deuxième couche de métal (30) en contact avec une partie centrale de la zone dopée, en ménageant un décalage (d) entre la couche de métal (30) et la périphérie:de la zone dopée.

## Claims

1. A power junction device comprising a substrate (10) of the SiCOI type with a silicon carbide layer (16) isolated from a bulk support (12) by a buried insulator layer (14), and comprising at least one Schottky contact between a first metal layer (40) and the silicon carbide surface layer (16), the first metal layer (40) forming an anode, the first metal layer (40) being in contact with a flank (36) of the silicon carbide layer (16) in order to form the Schottky contact therein, the flank forming an angle (β) measured with respect to a main face of the silicon carbide layer in contact with the buried insulator layer (14), having a value comprised between 20° and 80°, in consideration of which electric conduction in silicon carbide layer is effected parallel to the latter.

2. The device according to claim 1, wherein the angle (β) has a value close to 45°.

3. The device according to claim 1, comprising an insulator surface layer (24) covering the silicon carbide layer, and wherein the metal layer (40) forking an anode at least partly extends on a flank (34) of the insulator surface layer (24) covering the silicon carbide layer (16) and next to the flank (36) of the silicon carbide layer.

4. The device according to claim 1, comprising a second metal layer (30) in ohmic contact with the silicon carbide layer and forming a cathode.

5. The device according to claim 1, wherein the first metal layer (40), forming an anode, extends as far as on the bulk support in silicon.

6. The device according to claim 1, comprising at least one power diode and at least one transistor, the transistor having a channel formed in the silicon carbide layer.

7. The device according to claim 1, comprising a plurality of power diodes connected in series or in parallel.

8. The device according to claim 4, wherein the first and the second metal layers respectively have portions forming a comb, the comb-forming portions of the first and the second metal layers being interdigitated.

9. A method for manufacturing a power diode on a substrate of the SiCOI type with a silicon carbide layer (16) isolated from a bulk silicon support (12) by a buried insulator layer (14), the method comprising the following steps:
a) formation of an ohmic contact point on one face of the silicon carbide layer, opposite to the buried insulator layer,
b) localized etching of the silicon carbide layer outside a region of the ohmic contact in order to clear at least one side flank (36) on the silicon carbide layer (16), the flank forming an angle (β), measured with respect to a main face of the silicon carbide layer in contact with the buried insulator layer (14), having a value between 20° and 80°, and ) formation of a Schottky contact on the side flank according to claim 1.

10. The method according to claim 9, wherein the localized etching is etching using an etching mask and an etching agent with limited selectivity with respect to the etching mask, so as to give a slope to the side flank.

11. The method according to claim 9, wherein step a) comprises the formation of an insulator surface layer (24) on the silicon carbide layer.

12. The method according to claim 9, wherein the insulator surface layer (24) is used as an etching mask during step b).

13. The method according to claim 9, wherein the Schottky contact is formed between the first metal layer (40) and the silicon carbide layer (16), the first metal layer (40) being partly extended rover the insulator surface layer (24).

14. The method according to claim 9, wherein the Schottky contact is formed between the first metal layer (40) and the silicon carbide layer (16), the first metal layer (40) being extended as far as over the bulk support (12), through an aperture made beforehand in the buried insulator layer (14).

15. The method according to claim 9, wherein the step for forming an ohmic contact point comprises the formation of a doped area (20) in the silicon carbide layer, and then the deposition of a second metal layer (30) in contact with a central portion of the doped area, by making a shift (d) between the metal layer (30) and the periphery of the doped area.

## Patentansprüche

1. Leistungskontakt-Bauelement, umfassend ein Substrat (10) vom SiCOI-Typ mit einer Siliziumkarbid-Schicht (16), welche durch eine vergrabene Isolatorschicht (14) von einem massiven Träger (12) isoliert ist, und umfassend wenigstens einen Schottky-Kontakt zwischen einer ersten metallischen Schicht (40) und der Oberflächenschicht aus Siliziumkarbid (16), wobei die erste metallische Schicht (40) eine Anode bildet, wobei die erste metallische Schicht (40) in Kontakt mit einer Flanke (36) der Siliziumkarbid-Schicht (16) steht, um dort den Schottky-Kontakt zu bilden, wobei die Flanke einen Winkel ( bildet, gemessen in Bezug auf eine Hauptseite der Siliziumkarbid-Schicht in Kontakt mit der vergrabenen Isolatorschicht (14), der einen Wert zwischen 20° und 80° aufweist, wodurch die elektrische Leitung in der Siliziumkarbid-Schicht parallel zu dieser erfolgt.

2. Bauelement nach Anspruch 1, wobei der Winkel () einen Wert nahe an 45° aufweist.

3. Bauelement nach Anspruch 1, umfassend eine Oberflächen-Isolatorschicht (24), welche die Siliziumkarbid-Schicht abdeckt, und wobei die metallische Schicht (40), welche die Anode bildet, sich wenigstens teilweise auf eine Flanke (34) der Oberflächen-Isolatorschicht (24) erstreckt, welche die Siliziumkarbid-Schicht (16) abdeckt und an die Flanke (36) der Siliziumkarbid-Schicht anschließt.

4. Bauelement nach Anspruch 1, umfassend eine zweite metallische Schicht (30), die in Ohmschem Kontakt mit der Siliziumkarbid-Schicht
steht, und die eine Kathode bildet.

5. Bauelement nach Anspruch 1, wobei die erste metallische Schicht (40), welche die Anode bildet, sich bis auf den massiven Träger aus Silizium erstreckt.

6. Bauelement nach Anspruch 1 umfassend wenigstens eine Leistungsdiode und wenigstens einen Transistor, wobei der Transistor einen Kanal aufweist, der in der Siliziumkarbid-Schicht ausgebildet ist.

7. Bauelement nach Anspruch 1, umfassend eine Mehrzahl von seriell oder parallel geschalteten Leistungsdioden.

8. Bauelement nach Anspruch 4, wobei die erste und die zweite metallische Schicht jeweils Teile aufweisen, die eine Kammstruktur bilden, wobei die Teile der ersten und der zweiten Metallschicht, die die Kammstruktur bilden, ineinandergreifen.

9. Verfahren zur Herstellung einer Leistungsdiode auf einem Substrat vom SiCOI-Typ mit einer Siliziumkarbid-Schicht (16), die durch eine vergrabene Isolatorschicht (14) von einem massiven Träger aus Silizium (12) isoliert ist, wobei das Verfahren die folgenden Schritte umfasst:
a) das Bilden einer ohmschen Kontaktaufnahme auf einer Seite der Siliziumkarbid-Schicht, entgegengesetzt zu der vergrabenen Isolatorschicht,
b) das lokalisierte Ätzen der Siliziumkarbid-Schicht außerhalb eines ohmschen Kontaktbereichs, um wenigstens eine seitliche Flanke (36) auf der Siliziumkarbid-Schicht (16) freizulegen, wobei die Flanke einen Winkel ( 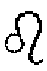 ) bildet, gemessen in Bezug auf eine Hauptseite der Siliziumkarbid-Schicht in Kontakt mit der vergrabenen Isolatorschicht (14), der einen Wert zwischen 20° und 80° aufweist, und
c) das Bilden eines Schottky-Kontakts auf der seitlichen Flanke gemäß Anspruch 1.

10. Verfahren nach Anspruch 9, wobei das lokalisierte Ätzen ein Ätzen unter Verwendung einer Ätzmaske und eines Ätzmittels mit einer in Bezug zur Ätzmaske begrenzten Selektivität ist, um eine Schräge auf die seitliche Flanke zu übertragen.

11. Verfahren nach Anspruch 9, wobei der Schritt a) umfasst, eine Oberflächen-Isolatorschicht (24) auf der Siliziumkarbid-Schicht zu bilden.

12. Verfahren nach Anspruch 9, wobei die Oberflächen-Isolatorschicht (24) beim Schritt b) als Ätzmaske verwendet wird.

13. Verfahren nach Anspruch 9, wobei der Schottky-Kontakt zwischen der ersten metallischen Schicht (40) und der Siliziumkarbid-Schicht (16) gebildet wird, wobei die erste metallische Schicht (40) teilweise auf die Oberflächen-Isolatorschicht (24) verlängert ist.

14. Verfahren nach Anspruch 9, wobei der Schottky-Kontakt zwischen der ersten metallischen Schicht (40) und der Siliziumkarbid-Schicht (16) gebildet wird, wobei die erste metallische Schicht (40) bis auf den massiven Träger (12) verlängert wird, über eine Öffnung hinweg, die zuvor in die vergrabenen Isolatorschicht (14) eingebracht wurde.

15. Verfahren nach Anspruch 9, wobei der Schritt des Bildens einer ohmschen Kontaktaufnahme das Bilden einer dotierten Zone (20) in der Siliziumkarbid-Schicht umfasst, dann das Aufbringen einer zweiten Metallschicht (30) in Kontakt mit einem zentralen Teil der dotierten Zone, wobei ein Abstand (d) zwischen der Metallschicht (30) und dem Umfang der dotierten Zone vorgesehen wird.
